Europäisches Patentamt

European Patent Office

Office européen des brevets

(11) Publication number: 0 487 797 A1

## EUROPEAN PATENT APPLICATION

(21) Application number: 90312948.4

(22) Date of filing: 28.11.90

(51) Int. Cl.⁵: G03F 3/10, G03F 7/075

(43) Date of publication of application:
03.06.92 Bulletin 92/23

(84) Designated Contracting States:
DE GB

(71) Applicant: TOYO INK MANUFACTURING CO.,
LTD.
No. 3-13, Kyobashi 2-chome Chuo-ku
Tokyo(JP)

(72) Inventor: Tsuchiko, Susumu
c/o Toyo Ink Manufacturing Co., Ltd.
3-13, Kyobashi 2-chome, Chuo-ku, Tokyo(JP)

(74) Representative: Myerscough, Philip Boyd et al
J.A.Kemp & Co. 14, South Square Gray's Inn
London, WC1R 5EU(GB)

(54) Image forming method.

(57) An image forming method using an image-forming material comprising a first substrate, a photosensitive layer, an ink layer which contains colorant and undergoes cohesive failure under thermal separation, and a second substrate, the method comprising the steps of:
(a) imagewise exposing the photosensitive layer on which an original image is placed,
(b) separating the second substrate under heat such that the part of the ink layer which is on an exposed portion of the photosensitive layer is retained and the part of the ink layer which is positioned on a nonexposed portion of the photosensitive layer is removed together with the second substrate, and
(c) bringing that part of the ink layer which is retained on the exposed portion of the photosensitive layer into contact with an image receptor under pressure such that the part of the ink layer which is retained on the exposed portion is transferred to the image receptor.

Field of the Invention

This invention relates to a method of forming an image, and more specifically to a method of forming an image of a single color or multicolors, which is capable of producing a high-quality transfer image nearly completely similar to an image produced with a printing machine from an image-forming material which exhibits a difference in cohesion and adhesion between exposed portion and nonexposed portion of a photosensitive layer of the image-forming material. In particular, this invention relates to a method which is capable of forming an image through a negative image mask. Description of the Prior Arts

In printing industry, it is general practice to use a proof sheet or a prepress proof sheet in order to check the finish and color tone of an image to be printed with a printing machine before actual printing.

The prepress proof has an advantage in that the finish of an image to be printed can be examined without using a printing ink, and an overlay method, a surprint method, etc., are properly used depending upon a final image quality, plate preparation and other requirements for a printing process.

In an overlay method, films which have a photosensitive layer containing a coloring material corresponding to a color separating mask are individually brought into contact with the corresponding mask, and subjected to exposure and development. Then, the films are overlaid one on another for proofing.

Differing from the overlay method, the surprint method can give a hard copy, and is highly useful. For example, as is described in U.S. Patents 3,060,023, 3,060,024 and 3,060,025, the surprint method is carried out by consecutively forming color separation images of photosensitive layers of photopolymers on a single image receptor.

Further, as described in JP-A-59-97410 and JP-A-61-188537, there is a prepress proof sheet which can be used both in the overlay method and the surprint method. This prepress proof sheet has an advantage in that it is usable as a general-purpose medium to a great extent depending upon purposes, i.e. it is used in an overlay method when it is necessary to check only characters, etc., and a formed image thereon is transferred to a receptor when a hard copy is required. However, this prepress proof sheet has a defect in that a working environment is put in a degraded condition due to a development step using an organic solvent.

It is also known to form a relief image by a dry separation development method, as is disclosed in JP-A-54-79032. This dry separation method is carried out by totallyseparating a transfer layer in the thickness direction, and it is therefore difficult to obtain an image similar to an image produced with a printing machine.

It is known that an image having a texture equivalent to that of an image produced with a printing machine can be obtained as follows: An image-forming material is prepared by forming a photosensitive layer containing a dye and/or a pigment on a transparent substrate so as to utilize a difference to be caused in adhesion between an exposed portion and a nonexposed portion in the photosensitive layer when the photosensitive layer is imagewise exposed. The image-forming material is used by passing it through the nip of roller after imagewise exposed, whereby a formed image is transferred to an image receptor. Differing from conventional prepress proof images, the image (prepress proof) formed on the image receptor by cohesion failure of the photosensitive layer under the transfer in the nip of rollers is a reproduction being equivalent to an image produced with a printing machine and having the same texture as that produced with a printing machine.

In the above method, however, the nonexposed portion constitutes an image portion. Therefore, the problem of said method is that, in order to obtain an image equivalent to that produced by a printing machine, no other film than a film of only a positive image can be used as an original image for the exposure.

Summary of the Invention

It is an object of this invention to provide a method of forming an image which is excellent in dot reproduction and color reproduction and which is very similar to an image produced by a printing machine.

It is another object of this invention to provide a method of forming an image, which makes it possible to omit a proof sheet to be prepared with a proof printing machine.

The first aspect of this invention is directed to a method of forming an image, which uses an image-forming material having a constitution comprising a first substrate, a photosensitive layer, an ink layer containing colorant and having a function of cohesive failure under thermal separation and a second substrate, the method comprising the steps of:

(a) imagewise exposing the photosensitive layer on which an original image is placed,

(b) separating the second substrate under heat thereby to retain that part of the ink layer which on an exposed portion of the photosensitive layer and remove that part of the ink layer which is positioned on a nonexposed portion of the photosensitive layer together with the second substrate, and

(c) bring that part of the ink layer which is retained on the exposed portion of the photosensitive layer into contact with an image receptor under pressure, thereby to transfer that part of the ink layer which is retained on the exposed portion to the image receptor.

The second aspect of this invention is directed to a method of forming an image, which uses an image-forming member A comprising a substrate A, a photosensitive layer containing a silicone compound having a polymerizable unsaturated double bond and a substrate A-1, and an image-forming member B comprising a substrate B and a colorant-containing ink layer formed on the substrate, the method comprising the steps of:

(d) imagewise exposing the image-forming member A on which an original image is placed,

(e) separating the substrate A-1 thereby to remove a whole of an exposed portion and part, in a thickness direction, of a nonexposed portion together with the substrate A-1,

(f) exposing the nonexposed portion of the photosensitive layer on the substrate A to cure it,

(g) bringing the ink layer on the substrate B into contact with a photosensitive layer surface on the substrate A under pressure, and thereafter separating the substrate B thereby to transfer the ink layer to that portion of the substrate A which is without the photosensitive layer, and

(h) transferring the ink layer transferred to the substrate A to an image receptor under pressure.

Detailed Description of the Invention

To begin with, the first aspect of this invention will be explained below.

The image-forming material used in the first aspect of this invention can be separated into a first image-forming member having a photosensitive layer on a first substrate and a second image-forming member having an ink layer on a second substrate. When the above image-forming material is used, the following method for forming an image is preferred.

An original image is placed on the first substrate of the first image-forming member, and thereafter, the second image-forming member is placed on the photosensitive layer of the first image-forming member such that the ink layer of the second image-forming member is brought into contact with the photosensitive layer. Then, the second substrate is separated under heat, whereby part of the ink layer remain in an exposed portion of the photosensitive layer and that part of the ink layer which is positioned in a nonexposed portion of the photosensitive layer is removed together with the second substrate. That part of the ink layer which is formed on the exposed portion of the photosensitive layer is brought into contact with an image receptor under pressure thereby to transfer that part of the ink layer to an image receptor.

The image-forming material used in the first aspect of this invention may be that which is prepared by consecutively forming the photosensitive layer and the ink layer on the first substrate and laminating the second substrate thereon. In the case of this image-forming material, the ink layer is required to be formed of a nonphotosensitive material. That is because it is necessary to prevent photosetting of the ink layer during the exposure.

In the first aspect of this invention, there is provided a method of forming a desirable image when the relationship in adhesion force among the photosensitive layer, the substrate, etc., meets the following inequalities.

$$f_1 \text{ and } f_4 > f_3 > f_2$$
$$f_4, f_5 \text{ and } f_6 > f_3$$

wherein:

$f_1$ = adhesion force between nonexposed portion of photosensitive layer and first substrate,

$f_2$ = cohesive force of photosensitive layer,

$f_3$ = adhesion force between ink layer and second substrate,

$f_4$ = cohesive force of ink layer,

$f_5$ = adhesion force between exposed portion of photosensitive layer and first substrate, and

$f_6$ = adhesion force between ink layer and image receptor.

This invention provides a method for forming an image according to a surprint method, in which an image having a texture equivalent to that of an image produced with a printing machine can be obtained simply, speedily and stably. Further, the method of this invention can be applied to an overlay method. That is, this invention provides a method which is capable of forming an image having a texture equivalent to that of an image produced with a printing machine, and further, it provides a color proof having stable quality by a dry development method free from a developer, i.e. by separation.

In the first aspect of this invention, the first image-forming member has a constitution comprising a first substrate, a photosensitive layer (which substantially does not contain any colorant) and optionally, a protective film, and will be explained below.

In the first aspect of this invention, the exposure is carried out preferably from the first substrate (transparent) side. This exposure method remarkably improves the positional relationships such as a direction of an image, etc., and obviates an intermediate image receptor to be used to correct the direction of an image.

Preferred as the first substrate are films or sheets of those materials which are stable to heat and chemicals and which are fully permeable to active light. Examples of such materials are cellulose acetate, polystyrene, polyvinyl chloride, polyethylene terephthalate, polycarbonate and polypropylene. A polyethylene terephthalate film or sheet is particularly preferred in view of transparency, thermal stability and dimensional stability. The first substrate may be provided with a suitable primer in order to adjust adhesion between the photosensitive layer and the first substrate.

Examples of the protective film are a polyethylene film, a polyethylene terephthalate film, a polypropylene film and a triacetate film.

In order to erase static electricity generated when the protective film is peeled, the first substrate or the protective film may be treated to impart it with electrical conductivity.

In the first aspect of this invention, the photosensitive layer contains a photopolymerizable compound, a photopolymerization initiator, etc., and in addition to these, the photosensitive layer may further contain a photopolymerization promoter, a thermoplastic resin, a thermal polymerization inhibitor, a resin-based plasticizer, a filler, an additive, etc. The photosensitive layer substantially does not contain any coloring matter such as a dye and a pigment. In addition, the photosensitive layer may contain a colorant to some extent in combination as far as the colorant does not affect the working of this invention.

The photopolymerizable compound is at least one member selected from a monomer, an oligomer and a prepolymer. Examples of the photopolymerizable compound are ethylenically unsaturated compounds such as (meth)acrylate, methyl (meth)acrylate, cyclohexyl (meth)acrylate, dimethylaminoethyl (meth)-acrylate, 2-hydroxyethyl (meth)acrylate, ethylene glycol diacrylate, diethylene glycol diacrylate, 1,6-hexanediol di(meth)acrylate, trimethylolpropane triacrylate, pentaerythritol triacrylate, dipentaerythritol hexaacrylate, N-methylol (meth)acrylamide, styrene, (meth)acrylate of alkylene oxide adduct of phenol, epoxy (meth)acrylate, urethane (meth)acrylate, polyester (meth)acrylate, and alkyd (meth)acrylate. These ethylenically unsaturated compounds may be used alone or in combination. Other photopolymerizable compounds such as cationic polymerization-type epoxy, etc., may be used.

Preferred as the thermoplastic resin are polymers which have thermoplasticity and excellent compatibility with a photopolymerizable compound and which are not photopolymerizable. Examples of the thermoplastic resin are polyvinyl chloride, poly(meth)acrylic ester, an epoxy resin, a polyurethane resin, a cellulose derivative (such as ethyl cellulose, cellulose acetate or nitrocellulose), a vinyl chloride-vinyl acetate copolymer, a polyamide resin, a polyvinyl acetal resin, a diallyl phthalate resin, and a synthetic rubber such as a butadiene-acrylonitrile. These thermoplastic resins may be incorporated alone or in combination.

Examples of the photopolymerization initiator are benzophenone, benzoin ethylester, benzyl methyl ketal, azobisisobutyronitrile, 2-chlorothioxanthone, 2-methylthioxanthone, 2-ethylthioxanthone, 2-isopropylthioxanthone, and 4'-isopropyl-2-hydroxy-2-methylpropiophenone. In order to improve the efficiency of photopolymerization initiation, a photopolymerization promoter may be used in combination. An aromatic-aliphatic tertiary amine, etc., are known as a promoter. Examples of the promoter are a Michler's ketone and 4,4'-bisdiethylamino-benzophenone. Some of the promoters cause a yellowing phenomenon. Hence, the promoter is selected with taking into account promotion efficiency and yellowing properties, compatibility with the initiator, and energy and wavelength region of active light.

Examples of the polymerization initiator are hydroquinone, p-methoxyphenol, t-butylcatechol and pyrogallol.

The photosensitive layer has a thickness of about 0.5 to about 5 $\mu$m. The photosensitive layer is usually formed by a coating method using a bar coater, a gravure coater, or the like.

The second image-forming member comprises a second substrate, an ink layer and optionally, a protective film. As the second substrate and the protective film, those films specified with regard to the first image-forming member can be used.

The ink layer may be nonphotosensitive or photosensitive. However, the nonphotosensitive layer has the following advantage. The first substrate is totally exposed after the (b) step of separating the second substrate under heat, whereby a partly remaining nonexposed portion of the photosensitive layer can be cured, and the resultant image is sharper than an image obtained without the whole surface exposure. An ordinary offset printing ink may be used as an ink layer. In order to coat an ink and preserve it in a layer form, the ink is desired to have an increased viscosity.

When it is desirable to dissipate adhesion nature of the ink layer transferred to an image receptor or to strengthen the bonding between an image receptor and the ink layer, the ink layer may be photosensitive. When the ink layer is photosensitive, the same materials as those specified with regard to the photosensitive layer of the first image-forming member are usable for the ink layer. However, the ink layer is required to have at least one layer containing a dye and/or a pigment.

As a colorant for use in the ink layer, conventional dyes and pigments such as an organic dye, carbon black, etc., can be used. A mixture of a plurality of dyes and pigments may be used in order to obtain a desired hue. For color proofing, there are used dyes and pigments which are similar to or identical with yellow, magenta, cyan and black in printing inks.

The amount of the pigment or the dye in the ink layer is 5 to 50 % based on the total solids content.

The ink layer has a thickness of about 0.5 to about 5 $\mu$m, and is formed with a bar coater, a gravure coater, or the like.

The ink layer has a constitution of one layer. However, it may comprise two layers or three layers. In this case, at least one layer contains a colorant. All the layers may contain a colorant.

In the first aspect of this invention, main factors are cohesive forces of the photosensitive layer and the ink layer, adhesion forces with the substrates and adhesion force with an image receptor. That is, the relationship among adhesion force (f1) between a nonexposed portion of the photosensitive layer and the first substrate in the first image-forming member, cohesive force (f2) of the photosensitive layer, cohesive force (f3) of the ink layer, and adhesion force (f4) between the ink layer and the second substrate in the second image-forming member preferably meets the following inequality,

$$f1 \text{ and } f4 > f3 > f2$$

and the relationship among adhesion force (f5) between exposed portion of the photosensitive layer and the first substrate in the first image-forming member, cohesive force (f3) of the ink layer, adhesion force (f4) between the ink layer and the second substrate in the second image-forming member and adhesion force (f6) between the ink layer and an image receptor preferably meets the following inequality,

$$f4, f5 \text{ and } f6 > f3.$$

The above adhesion forces and cohesive forces are adjusted by controlling the compositions and compositional ratios of the photosensitive layer and the ink layer, whereby the above relationships can be achieved. For example, when the photosensitive layer and the ink layer are formed of the same material, the intended relationships can be achieved by changing the compositional ratios thereof, particularly by changing the compositional ratio between a photopolymerizable compound and a resin.

In the first aspect of this invention, it is not necessary to prepare the first image-forming member and the second image-forming member separately, and the image-forming material may be prepared by forming a constitution without a protective film, i.e. a constitution of first substrate/photosensitive layer/ink layer/second substrate. The image-forming material having such a constitution is preferred economically and in view of transfer machine designing.

The following is a step-by-step explanation of how the above image-forming material according to the first aspect of this invention is used, e.g. as an image-forming material for color proofing.

(1) A negative, color separating image mask and the first image-forming member are provided with holes for register pins. An image receptor, if it is paper, etc., is also provided with holes for register pins.

(2) Imagewise exposure is carried out. That is, the photosensitive layer is imagewise exposed to active light such as UV ray through the color separating mask sufficiently to cure it. The protective layer is removed if it is used.

(3) Then, the first image-forming member and the second image-forming member are positioned such that the photosensitive layer and the ink layer face each other between heating rollers, and these two members are directed into the nip of the rollers. These two members are brought into contact in the nip of the rollers to transfer ink layer to the photosensitive layer, and these two members are separated after they have passed the nip.

(4) The first image-forming member obtained in the above step (3) is totally exposed.

(5) The ink layer formed on the photosensitive layer of the first image-forming member is transferred to the image receptor by passing the first image-forming material and the image receptor through the nip of rollers in the same way as in the above step (3). This transfer is usually carried out under heat.

Alternatively, the image-forming material according to the first aspect of this invention is used as follows.

(6) The negative, color separating image mask and the image-forming material comprising a first substrate, a photosensitive layer, an ink layer and a second substrate are provided with holes for register pins. Further, an image receptor, if it is paper, etc., is also provided with holes for register pins.

(7) Imagewise exposure is carried out. That is, the photosensitive layer is imagewise exposed to active light such as UV ray through a color separating mask sufficiently to cure the image-forming material.

(8) Then, the second substrate is separated, e.g. after the image-forming material has passed the nip of rollers, whereby the photosensitive layer and the ink layer on a cured portion of the photosensitive layer remain. The remaining image-forming material is totally exposed.

(9) The remaining image-forming material and an image receptor are positioned such that the remaining ink layer and the image receptor face each other, and directed into the nip of rollers. These image-forming material and the image receptor are brought into contact in the nip of rollers to transfer the ink layer, and the first substrate and the image receptor are separated after these have passed the nip.

The above steps (1) to (5) or (6) to (9) are repeated, e.g. four times (yellow, magenta, cyan and black) for color proofing, whereby a four-color reproduction image can be obtained.

In addition, examples of the image receptor are those materials which are generally used for proof printing such as art paper, coat paper, etc. However, these materials shall not impose any limitation on this invention.

This invention will be explained below with regard to its second aspect.

According to the second aspect of this invention, there is provided a method of forming an image, which uses an image-forming member A comprising a substrate A, a photosensitive layer containing a silicone compound having a polymerizable unsaturated double bond and a substrate A-1, and an image-forming member B comprising a substrate B and a colorant-containing ink layer formed on the substrate, the method comprising the steps of:

(d) imagewise exposing the image-forming member A on which an original image is placed,

(e) separating the substrate A-1 thereby to remove a whole of an exposed portion and part, in a thickness direction, of a nonexposed portion together with the substrate A-1,

(f) exposing the nonexposed portion of the photosensitive layer on the substrate A to cure it,

(g) bringing the ink layer on the substrate B into contact with the photosensitive layer on the substrate A under pressure, and thereafter separating the substrate B thereby to transfer the ink layer to that portion of the substrate A which is without the photosensitive layer, and

(h) transferring the ink layer transferred to the substrate A to an image receptor under pressure.

In the second aspect of this invention, the relationship among adhesion force between the substrate A and the photosensitive layer, and the like preferably meets the following inequalities, whereby a satisfactory image can be obtained,

$$f7 > f8$$
$$f10 \geqq f9 > f11$$

wherein:

f7 = adhesion force between exposed portion of photosensitive layer and substrate A-1,

f8 = adhesion force between exposed portion of photosensitive layer and substrate A,

f9 = adhesion force between nonexposed portion of photosensitive layer and substrate A,

f10 = adhesion force between nonexposed portion of photosensitive layer and substrate A-1, and

f11 = cohesive force of nonexposed portion of photosensitive layer.

In the second aspect of this invention, the above steps (e), (g) and (h) are preferably carried out under heat.

In the second aspect of this invention, the image-forming member A usually has a constitution comprising a first substrate A, a photosensitive layer containing a silicone compound having a polymerizable unsaturated double bond and a substrate A-1.

In the second aspect of this invention, the exposure is also preferably carried out from the substrate A (transparent) side. This exposure method remarkably improves the positional relationships such as a direction of an image, etc., and obviates an intermediate image receptor to be used to correct the direction of an image.

As a material for the substrate A, preferred are those which have been specified with regard to the first substrate in the first aspect of this invention.

Examples of the substrate A-1 are a polyethylene film, a polyethylene terephthalate film, polypropylene film, triacetate film, a film prepared by forming an evaporation film or sputtered film of aluminum, etc., on one of the above films, and a composite film formed by combining a plastic film and a metal foil.

In the second aspect of this invention, the photosensitive layer is a layer containing a silicone compound having a polymerizable unsaturated double bond such as silicon (meth)acrylate, etc., and it may further contain other photopolymerizable compound as required. Further, it may contain a photopolymerization initiator, a resin-based plasticizer, a filler, an additive, etc., in combination. The photosensitive layer may further contain a colorant such as a dye or a pigment.

The silicone compound having a polymerizable unsaturated double bond is required to be easily cured with light irradiation, and is required not to receive that ink layer containing a dye and/or a pigment which is applied at a later step while the silicone compound is in a cured state. In addition, even when the photosensitive layer is in a noncured state, it is naturally required to have a property with which to receive no ink layer. When a transfer image for color proofing is prepared by carrying out the transfer a plurality of times, a nonexposed portion of the photosensitive layer is transferred to an image receptor or the ink layer which has already transferred to an image receptor, and the transfer of another ink layer is sometimes prevented. It is therefore required to have cured the photosensitive layer.

Examples of the silicone compound having a polymerizable unsaturated double bond are an organopolysiloxane containig a siloxane unit to which an optionally substituted maleimide group is bonded, an organopolysiloxane containing a siloxane unit to which an optionally substituted acryloxy group is bonded, a mixture of an organopolysilixane having, in the molecule, a silixane unit to which at least one mercapto group is bonded and an organopolysiloxane having, in the molecule, a silixane unit to which at least one vinyl group is bonded, and a mixture of an organopolysiloxane having, in the molecule, a siloxane unit to which at least one vinyl group is bonded and an organohydrodienepolysiloxane. In view of UV ray curability, an organopolysiloxane having a (meth)acryloxy group is preferred. These compounds may be used alone or in combination.

The content of the silicone compound having a polymerizable unsaturated double bond in the photosensitive layer is about 1 to about 60 % by weight. When this content is less than 1 % by weight, the photosensitive layer cannot be sufficiently imparted with the property of receiving no ink layer, and the ink layer is received at a later step and is a cause for scumming. When the above content is more than 60 % by weight, no problem is posed concerning the property of receiving no ink layer. Since, however, the silicone compound is expensive, the use of such a large amount of the silicone compound is not economical.

The other photopolymerizable compound, the thermoplastic resin, the photopolymerization initiator and the thermal polymerization inhibitor can be suitably selected from those specified with regard to the first aspect of this invention.

In the second aspect of this invention, the photosensitive layer has a constitution which mainly comprises a silicone compound having a polymerizable unsaturated double bond, other photopolymerizable compound and a thermoplastic resin, and the compositional ratio of these components differs depending upon materials thereof. However, when the photosensitive layer is formed as such in the image-forming member A, the compositional ratio is selected such that the photosensitive layer exhibits a solid state or a slightly adhering state.

The photosensitive layer has a thickness of about 0.5 to about 5 $\mu$m, and formed by a usual coating method using a bar coater, a gravure coater, or the like.

The image-forming member B for use in the above step (g) comprises a substrate B, an ink layer and optionally, a protective film. The substrate B and the protective film are selected from films for use as the substrates A and A-1 of the above image-forming member A.

The ink layer may be photosensitive or nonphotosensitive. Therefore, a conventional offset printing ink may be used. In order to coat an ink and preserve it in a layer form, the ink is desired to have an increased viscosity.

In order to dissipate adhesion nature of the ink layer transferred to an image receptor or strengthen adhesion between the image receptor and the ink layer, a photosensitive ink layer is more preferred. In order to form the photosensitive ink layer, the same materials as those for the photosensitive layer of the image-forming member A may be used except for the silicone compound having a polymerizable unsaturated double bond.

The colorant for use in the ink layer is suitably selected from the dyes and pigments used in the image-forming material in the first aspect of this invention.

The preferred content of the dye or pigment in the ink layer is 5 to 50 % by weight based on the total solids content.

The ink layer has a thickness of about 0.5 to about 5 $\mu$m, and it is formed with a bar coater, gravure coater, or the like.

The ink layer has a constitution of one layer. However, it may comprise two layers or three layers. In this case, at least one layer contains a colorant. All the layers may contain a colorant.

Adhesion forces in the image-forming material will be explained below.

Concerning adhesion forces between the photosensitive layer and the substrate A and between the photosensitive layer and the substrate A-1, the adhesion force between an exposed portion of the photosensitive layer and the substrate A-1 is higher than the adhesion force between an exposed portion of the photosensitive layer and the substrate A. And, with regard to a nonexposed portion of the photosensitive layer, there is an inequality of adhesion force to the substrate A-1 ≧ adhesion force to the substrate A > cohesive force of the photosensitive layer. The above relationships are preferred to obtain a desirable image.

The above relationships can be achieved by one of the following methods.

(1) The substrate A and the substrate A-1 are selected from the same material. And, a liquid for the photosensitive layer is coated on the substrate A-1 and dried, and the coated substrate A-1 is laminated on the substrate A. Otherwise, the photosensitive layer is formed so as to have a multilayer constitution, in which a photosensitive layer having low adhesion property is formed on the substrate A and a photosensitive layer having high adhesion property is formed on the substrate A-1.

(2) The substrate A and the substrate A-1 are selected from the same material, and treated so as to differentiate adhesion force of one from that of the other. For example, the substrate A is not treated, and the substrate A-1 is subjected to corona discharge treatment to impart it with easy adhesion property.

(3) One material is selected for the substrate A, and another material is selected for the substrate A-1. For example, nontreated polyethylene terephthalate is selected for the substrate A, and a plastic film having a metal foil or a metal layer is selected for the substrate A-1.

In addition, the adhesion forces in the first aspect of this invention may be controlled in the same manner as above.

The following is a step-by-step explanation of how the above image-forming material according to the second aspect of this invention is used, e.g. as an image-forming material for color proofing.

(1) A negative, color separating mask and the image-forming member A are provided with holes for register pins. An image receptor, if it is paper, etc., is also provided with holes for register pins.

(2) Imagewise exposure is carried out. That is, the photosensitive layer is imagewise exposed to active light such as UV ray through the color separating mask sufficiently to cure the photosensitive layer.

(3) Then, in the nip of heating rollers, the substrate A-1 is separated thereby to remove the whole of an exposed portion of the photosensitive layer and part, in the thickness direction, of a nonexposed portion of the photosensitive layer (breakaway of the nonexposed portion by cohesive failure). As a result, part of the nonexposed portion is formed on the substrate A.

(4) The nonexposed portion of the photosensitive layer on the substrate A is totally exposed.

(5) The ink layer formed on the substrate B is positioned such that the ink layer faces the photosensitive layer of the substrate A, and these two members are directed to the nip of rollers and brought into contact with each other under pressure to transfer ink layer to the photosensitive layer, and these two members are separated after they have passed the nip.

(6) The ink layer on the substrate A and an image receptor are arranged such that these two members face each other, and the ink layer is transferred in the same manner as in the above step (5).

(7) When the ink layer transferred to the image receptor has photosensitivity, the ink layer is post-exposed.

The contact under pressure and the transfer in the above steps (5) and (6) are usually carried out under heat as required.

The above steps (1) to (7) repeated, e.g. four times (yellow, magenta, cyan and black) for color proofing, whereby a four-color reproduction image can be obtained.

According to this invention, the contact and transfer can be carried out easily and speedily.

The contact and transfer between the photosensitive layer and the ink layer, and that between the ink layer and the image receptor are usually carried out under pressure and heat, but may be carried out under only pressure. When the transfer is carried out under heat, the heating temperature is lower than a temperature at which the image receptor is elongated or shrunk to a great extent. For example, when the roller has a surface temperature of 50 to 150°C, preferably 70 to 110°C, the transfer rate and the reproduction accuracy of a fine image can be improved. That is, the transfer can be carried out excellently without mottling and picking.

When two roller are used, there may be a surface temperature difference between the rollers. For example, one roller is heated, and the other is cooled.

As an apparatus for carrying out the transfer between rollers, a conventional laminator may be used.

According to this invention, an image having a texture very similar to that of an image produced with a printing machine can be easily reproduced on an image receptor from a negative film. Further, an image having excellent dot reproduction and color reproduction and being equivalent to an image produced with a proof printing machine can be obtained. It is therefore possible to omit proofing with a printing machine.

This invention will be explained further in detail by reference to Examples, which, however, shall not limit this invention. In Examples, "part" stands for "part by weight".

Example 1

A liquid for a photosensitive layer was prepared from the following components.

| | |
|---|---|
| Diallyl isophthalate prepolymer (Daiso Isodap, supplied by Osaka Soda Co., Ltd.) | 17.0 parts |
| Dipentaerythritol hexaacrylate | 11.3 parts |
| Benzophenone | 0.02 part |
| 4,4-bisdiethylaminobenzophenone | 0.07 part |
| Hydroquinone | 0.001 part |
| Methyl ethyl ketone | 10.8 parts |
| Toluene | 10.8 parts |

This liquid was coated on a polyethylene terephthalate film (thickness 12 $\mu$m) as a first substrate such that a dried coating had a thickness of 1.5 $\mu$m, and a polyethylene film (thickness 40 $\mu$m) as a protective film was laminated thereon at room temperature to give a first image-forming member.

Then, a liquid for an layer was prepared from the following components.

| | |
|---|---|
| Daiso Isodap | 75.6 parts |
| Dibutyl phthalate | 32.4 parts |
| Carbon black MA-7 (supplied by Mitsubishi Chemical Ind.) | 12.0 parts |
| Methyl ethyl ketone | 180.0 parts |

This liquid was coated on a polyethylene terephthalate film (thickness 12 $\mu$m) as a second substrate such that a dried coating had a thickness of 3.0 $\mu$m, whereby a second image-forming member was obtained.

A negative image film was placed on the first image-forming member such that the emulsion surface of the negative image film was in contact with the substrate side of the first image-forming member, the first image-forming member was imagewise exposed, and the protective film was peeled off. Then, the first image-forming member and the second image-forming member were positioned such that the photosensitive layer and the ink layer faced each other, and these members were brought into contact with each other in the nip of rollers. And, immediately after these two members passed the nip, they were separated from each other, whereby an ink layer whose thickness was about 1/2 times as large as that of the original ink layer was formed on the cured photosensitive layer of the first image-forming member. Then, the first image-forming member was totally exposed to cure an uncured portion of the photosensitive layer.

The newly formed ink layer was transferred to an art paper sheet as an image receptor in the nip of rollers, and the first image-forming member and the art paper sheet were separated from each other immediately after they passed the nip, whereby a positive image equivalent to an image produced with a printing machine was obtained.

Further, four first image-forming members were prepared in the same way as above. Liquids for cyan, magenta and yellow ink layers were prepared in the same way as in the above preparation of the liquid for a photosensitive ink layer except that the carbon black MA-7 was replaced with Lionol Blue FG7330, Carmine 7BFG4412 and Lionol Yellow FG1310 (all manufactured by Toyo Ink Manufacturing Co., Ltd.), and four second image-forming members were prepared by using these liquids in the same way as above. And, the above procedure for transferring an image was repeated four times by using the above first and second image-forming members (four sheets each), four negative image films prepared by separating an original color image into four colors of black, magenta, cyan and yellow and one art paper sheet, whereby an image equivalent to a full color image produced with a printing machine was obtained.

In addition, the conditions for exposure to UV ray and a laminator used above were as follows.

Exposure to UV ray (UV apparatus, ORCHMW-201KB, supplied by Orc Seisakusho):
Image exposure - 100 mJ/cm$^2$
Whole surface exposure - 500 mJ/cm$^2$

Laminator:

Upper roller - rubber roller having a diameter of 150 mm, a temperature of 50°C, a width of 300 mm and a Shore hardness A of 70.
Lower roller - chromium-plated metal roller having a diameter of 150 mm, a temperature of 50°C and a width of 300 mm.
Nip portion - 10 mm
Feed rate - 50 mm/minute
Nip pressure - 4 kg/cm$^2$ (compressor pressure in two air cylinders having a diameter of 3 cm)

Example 2

A liquid for a photosensitive layer was prepared from the following components.

| | |
|---|---:|
| Urethane acryl prepolymer USA-10 (supplied by Sanyo-Kokusaku Pulp Co., Ltd.) | 40 parts |
| Aronix M-315 (supplied by Toa Gosei Co., Ltd.) | 60 parts |
| Benzophenone | 3 parts |
| 4,4-bisdiethylaminobenzophenone | 1 part |
| Methyl ethyl ketone | 100 parts |

This liquid for a photosensitive layer was coated on a polyethylene terephthalate film (thickness 12 $\mu$m) as a first substrate such that a dried coating had a thickness of 1.5 $\mu$m, whereby a first image-forming member was obtained. The same second image-forming member as that prepared in Example 1 was laminated on the first image-forming member such that the ink layer of the second image-forming member was in contact with the photosensitive layer of the first image-forming material, whereby an image-forming material was obtained. A negative film was placed on the image-forming material such that the emulsion surface of the negative film was in contact with the first substrate side of the image-forming material, and the image-forming material was imagewise exposed and allowed to pass the nip of rollers. Immediately thereafter, the second substrate was peeled off, whereby an ink layer whose thickness was about 1/2 times as large as that of the original ink layer was retained on a cured portion of the photosensitive layer. The resultant image-forming material was totally exposed to cure an uncured portion of the photosensitive layer.

The retained ink layer was transferred to an art paper sheet in the same way as in Example 1 to give a positive image which was equivalent to an image produced by a printing machine.

Further, four first image-forming members were prepared in the same way as above. Liquids for cyan, magenta and yellow ink layers were prepared in the same way as in the preparation of the liquid for a photosensitive ink layer in Example 1 except that the carbon black MA-7 was replaced with Lionol Blue FG7330, Carmine 7BFG4412 and Lionol Yellow G1310 (all manufactured by Toyo Ink Manufacturing Co., Ltd.), and second image-forming members were prepared by coating each of these liquids on a polyethylene terephthalate film in the same way as in Example 1. And, each of the second image-forming members was laminated on the first image-forming member in the same way as above, whereby four image-forming materials were obtained. The above procedure for transferring an image was repeated four times by using the above four image-forming materials and four negative image films prepared by separating an original color image into four colors of black, magenta, cyan and yellow, whereby an image equivalent to a full color image produced with a printing machine was obtained.

In addition, the above four first image-forming members could be used four times each.

Example 3

A liquid for a photosensitive layer was prepared from the following components.

| Diallyl isophthalate prepolymer (Daiso Isodap, supplied by Osaka Soda Co., Ltd.) | 17.0 parts |
|---|---|
| Dipentaerythritol hexaacrylate | 11.3 parts |
| Benzophenone | 0.02 part |
| 4,4-bisdiethylaminobenzophenone | 0.07 part |
| Hydroquinone | 0.001 part |
| Methyl ethyl ketone | 10.8 parts |
| Toluene | 10.8 parts |

This liquid was coated on a polyethylene terephthalate film (thickness 12 $\mu$m) as a first substrate such that a dried coating had a thickness of 1.5 $\mu$m, and a polyethylene film (thickness 40 $\mu$m) as a protective film was laminated thereon at room temperature to give a first imageforming member.

Then, a liquid for a photosensitive ink layer was prepared from the following components.

| Daiso Isodap | 75.6 parts |
|---|---|
| Dibutyl phthalate | 32.4 parts |
| Carbon black MA-7 (supplied by Mitsubishi Chemical Ind.) | 12.0 parts |
| Benzophenone | 6.0 parts |
| 4,4-bisdiethylaminobenzophenone | 2.0 parts |
| Methyl ethyl ketone | 180.0 parts |

This liquid was coated on a polyethylene terephthalate film (thickness 12 $\mu$m) as a second substrate such that a dried coating had a thickness of 3.0 $\mu$m, whereby a second image-forming member was obtained.

A negative image film was placed on the first image-forming member such that the emulsion surface of the negative image film was in contact with the substrate side of the first image-forming member, the first image-forming member was imagewise exposed, and the protective film was peeled off. Then, the first image-forming member and the second image-forming member were positioned such that the photosensitive layer and the ink layer faced each other, and these members were brought into contact with each other in the nip of rollers. And, immediately after these two members passed the nip, they were separated from each other, whereby an ink layer whose thickness was about 1/2 times as large as that of the original ink layer was formed on the cured photosensitive layer of the first image-forming member.

The newly formed ink layer was transferred to an art paper sheet as an image receptor in the nip of rollers. And, immediately after the first image-forming member and the art paper sheet passed the nip, they were separated from each other and the transferred ink layer was post-exposed, whereby a positive image equivalent to an image produced with a printing machine was obtained on the art paper.

Further, the above first image-forming member (which was used once as above) and a newly prepared second image-forming member were used to carry out the same transfer as above, whereby the same image as above was obtained.

When this first image-forming material was also used twice more in the same way as above, the same images as above were obtained.

Furthermore, four first image-forming members were prepared in the same way as above. Liquids for cyan, magenta and yellow ink layers were prepared in the same way as in the above preparation of the liquid for a photosensitive ink layer except that the carbon black MA-7 was replaced with Lionol Blue FG7330, Carmine 7BFG4412 and Lionol Yellow FG1310 (all manufactured by Toyo Ink Manufacturing Co., Ltd.), and four second image-forming members were prepared by using these liquids in the same way as above. And, the above procedure for transferring an image was repeated four times by using the above first and second image-forming members (four sheets each), four negative image films prepared by separating an original color image into four colors of black, magenta, cyan and yellow and one art paper sheet, whereby an image equivalent to a full color image produced with a printing machine was obtained.

In addition, the conditions for exposure to UV ray and a laminator used above were as follows.

Exposure to UV ray (UV apparatus, ORCHMW-201KB, supplied by Orch Seisakusho):

Image exposure - 100 mJ/cm$^2$

Post exposure - 500 mJ/cm$^2$

Laminator:

Upper roller - rubber roller having a diameter of 150 mm, a temperature of 50°C, a width of 300 mm and a Shore hardness A of 70.

Lower roller - chromium-plated metal roller having a diameter of 150 mm, a temperature of 50°C and a width of 300 mm.

Nip portion - 10 mm

Feed rate - 50 mm/minute

Nip pressure - 4 kg/cm$^2$ (compressor pressure in two air cylinders having a diameter of 3 cm)

Example 4

A liquid for a photosensitive layer was prepared from the following components.

| | |
|---|---|
| Urethane acryl prepolymer USA-10 (supplied by Sanyo-Kokusaku Pulp Co., Ltd.) | 40 parts |
| Aronix M-315 (supplied by Toa Gosei Co., Ltd.) | 60 parts |
| Benzophenone | 3 parts |
| 4,4-bisdiethylaminobenzophenone | 1 part |
| Methyl ethyl ketone | 100 parts |

This liquid for a photosensitive layer was coated on a polyethylene terephthalate film (thickness 12 μm) as a first substrate such that a dried coating had a thickness of 1.5 μm, and a polyethylene terephthalate film (thickness 40 μm) as a protective film was laminated thereon at room temperature, whereby a first image-forming member was obtained. This procedure was further repeated to form the same four first image-forming members in total.

Further, four second image-forming members were prepared in the same way as in Example 3. And, the procedure for forming an image in Example 3 was repeated by using these first and second image-forming members, four negative films and one art paper, whereby a positive image equivalent to an image produced with a printing machine was obtained.

Furthermore, each of the above four first image-forming members could be used four times.

Example 5

A liquid for a photosensitive layer was prepared from the following components.

| | |
|---|---|
| Diallyl isophthalate prepolymer (Daiso Isodap, supplied by Osaka Soda Co., Ltd.) | 18.4 parts |
| Dipentaerythritol hexaacrylate | 9.91 parts |
| Silicone acrylate RC300 (supplied by TH Gold Schmidt Japan K.K.) | 1.42 parts |
| Benzophenone | 0.5 part |
| 4,4-bisdiethylaminobenzophenone | 0.17 part |
| Hydroquinone | 0.001 part |
| Methyl ethyl ketone | 40 parts |
| Toluene | 38 parts |

This liquid was coated on a corona discharge-treated surface of a polyethylene terephthalate film (thickness 50 μm) as a substrate A-1 such that a dried coating had a thickness of 1.4 μm. Then, a polyethylene terephthalate film (thickness 12 μm, treated with no corona discharge) as a substrate A was laminated the coated surface of the substrate A-1, whereby an image-forming material A was obtained.

A negative mask was placed on this image-forming material such that the emulsion surface of the negative mask was in contact with the substrate A, and the image-forming member A was imagewise exposed and allowed to pass through a heated laminator. The substrate A and the substrate A-1 were separated from each other immediately after they passed the laminator, whereby a nonexposed photosensitive layer only was formed on the substrate A. This nonexposed photosensitive layer was totally exposed to cure it.

A liquid for a photosensitive ink layer was prepared from the following components.

| Daiso Isodap | 17.0 parts |
| Dipentaerythritol hexaacrylate | 11.32 parts |
| Benzophenone | 0.5 part |
| 4,4-bisdiethylaminobenzophenone | 0.17 part |
| Hydroquinone | 0.001 part |
| Carbon black MA-7 (supplied by Mitsubishi Chemical Ind.) | 3.0 parts |
| Toluene | 38.0 parts |
| Methyl ethyl ketone | 40.0 parts |

This liquid was coated on a polyethylene terephthalate film (thickness 12 $\mu$m) as a substrate B such that a dried coating had a thickness of 2.0 $\mu$m, whereby a second image-forming member was obtained.

The photosensitive layer on the substrate A and the second image-forming member B were positioned such that the photosensitive layer faced the ink layer on the substrate B. And, the photosensitive layer and the ink layer were brought into contact in the nip of rollers under heat and pressure, and separated immediately after these two members passed the nip, whereby the ink layer was transferred to that portion of the substrate A which had no photosensitive layer.

The ink layer on the substrate A was brought into contact with an art paper sheet as an image receptor under pressure in the nip of heated rollers, and these two were separated immediately after they passed the nip. Further, the transferred ink layer was post-exposed, whereby a positive image whose finish was equivalent to that of an image produced by a printing machine was formed on the art paper sheet.

Further, the above substrate A having only the exposed photosensitive layer was used ten times to transfer an ink layer to the substrate A and transfer the ink layer transferred thereto to an art paper sheet, whereby ten images whose finishes were equal were obtained.

In addition, the conditions for exposure to UV ray and a laminator used above were as follows.

Exposure to UV ray (UV apparatus, ORCHMW-201KB, supplied by Orch Seisakusho):

Image exposure - 100 mJ/cm$^2$

Post exposure - 500 mJ/cm$^2$

Laminator:

Upper roller - rubber roller having a diameter of 150 mm, a temperature of 50°C, a width of 300 mm and a Shore hardness A of 70.

Lower roller - chromium-plated metal roller having a diameter of 150 mm, a temperature of 50°C and a width of 300 mm.

Nip portion - 10 mm

Feed rate - 50 mm/minute

Nip pressure - 4 kg/cm$^2$ (compressor pressure in two air cylinders having a diameter of 3 cm)

Example 6

A liquid for a photosensitive layer was prepared from the following components.

| Shin-etsu Silicone KR216 (supplied by Shin-etsu Chemical Ind. Co., Ltd.) | 60 parts |
| Silicone acrylate RC802 (supplied by TH Gold Schmidt Japan K.K.) | 10 parts |
| Benzophenone | 3 parts |
| 4,4-bisdidethylaminobenzophenone | 1 part |
| Hydroquinone | 0.005 part |
| Methyl ethyl ketone | 40 parts |
| Toluene | 38 parts |

This liquid was coated on a polyethylene terephthalate film (thickness 12 $\mu$m, Melinex 313, supplied Imperial Chemical Industry) as a substrate A-1 in the same way as in Example 5, and the same substrate A as that in Example 5 was laminated on the substrate A-1, whereby an image-forming member A was obtained.

The procedures (exposure, separation and whole surface exposure) for forming an image in Example 5 were repeated by using four color-separated negative masks (yellow, magenta, cyan and black) and the same four image-forming member A as that prepared above, whereby four substrates A which individually had a cured photosensitive layer were obtained.

The procedure for the preparation of the liquid for an ink layer in Example 5 was repeated. Liquids for cyan, magenta and yellow photosensitive ink layers were prepared in the same way as in Example 5 except that the carbon black was replaced with Carmine BFG4412, Lionol Blue FG7330 and Lionol Yellow FG1310 (all manufactured by Toyo Ink Manufacturing Co., Ltd.), and image-forming members B were prepared in the same way as in Example 5.

The procedures (contact under pressure in the nip of rollers, transfer and separation) for forming an image in Example 5 were repeated by using the above four substrates A and the above four image-forming members B, whereby four substrates A which individually had the ink layer where no photosensitive layer was present were obtained.

The ink layers on the substrates A were transferred to one art paper sheet and post-exposed in the same way as in Example 5, whereby a full color positive image whose finish was equivalent to that of an image produced with a printing machine was obtained.

The above four substrates which individually had the cured photosensitive layer were used ten times to form ten full color images, whose finishes were almost equal.

## Claims

1. A method of forming an image using an image-forming material comprising a first substrate, a photosensitive layer, an ink layer which contains colorant and undergoes cohesive failure under thermal separation, and a second substrate, the method comprising the steps of:
   (a) imagewise exposing the photosensitive layer on which an original image is placed,
   (b) separating the second substrate under heat such that the part of the ink layer which is on an exposed portion of the photosensitive layer is retained and the part of the ink layer which is positioned on a nonexposed portion of the photosensitive layer is removed together with the second substrate, and
   (c) bringing that part of the ink layer which is retained on the exposed portion of the photosensitive layer into contact with an image receptor under pressure such that the part of the ink layer which is retained on the exposed portion is transferred to the image receptor.

2. A method according to claim 1 wherein the image-forming material comprises a first image-forming member having the photosensitive layer on the first substrate and a second image-forming member having the ink layer on the second substrate.

3. A method according to claim 2, wherein the step (b) is carried out after the first image-forming member is imagewise exposed and after the second image-forming member is laminated on the photosensitive layer such that the ink layer of th second image-forming member is in contact with the photosensitive layer.

4. A method according to any one of the preceding claims wherein the image-forming material is a laminate comprising in order, the photosensitive layer, the ink layer and the second substrate, on the first substrate.

5. A method according to any one of the preceding claims wherein, in step (a), the original image is placed on the opposite side of the first substrate from the photosensitive layer.

6. A method according to any one of the preceding claims wherein the ink layer is photosensitive.

7. A method according to any one of claims 1 to 5 wherein the ink layer is nonphotosensitive.

8. A method according to claim 7, wherein step (c) is carried out after the first substrate has been totally exposed and after step (b).

9. A method according to any one of the preceding claims wherein the photosensitive layer is substantially free from dye and/or pigment.

10. A method according to any one of the preceding claims wherein the image-forming material and the image receptor satisfy the following inequalities,

f1 and f4 > f3 > f2
f4, f5 and f6 > f3

wherein:
f1 = adhesion force between nonexposed portion of photosensitive layer and first substrate,
f2 = cohesive force of photosensitive layer,
f3 = adhesion force between ink layer and second substrate,
f4 = cohesive force of ink layer,
f5 = adhesion force between exposed portion of photosensitive layer and first substrate, and
f6 = adhesion force between ink layer and image receptor.

11. A method according to any one of the preceding claims wherein the ink layer comprises 1 to 3 layers, at least one of which contains a colorant.

12. A method according to any one of the preceding claims wherein the ink layer is transferred to the image receptor under heat and pressure.

13. A method according to any one of the preceding claims wherein the image-forming material comprises an image-forming member A comprising a substrate A, a photosensitive layer containing a silicone compound having a polymerizable unsaturated double bond and a substrate A-1, and an image-forming member B comprising, or a substrate B, a colorant containing ink layer, the method comprising:
(d) imagewise exposing the image-forming member A on which an original image is placed,
(e) separating the substrate A-1 such that the whole of an exposed portion and part, in a thickness direction, of a nonexposed portion of the photosensitive layer are removed together with the substrate A-1,
(f) exposing the nonexposed portion of the photosensitive layer on the substrate A to cure it,
(g) bringing the ink layer on the substrate B into contact with a photosensitive layer surface on the substrate A under pressure, and thereafter separating the substrate B such that the ink layer is transferred to that portion of the substrate A which is without the photosensitive layer, and
(h) transferring the ink layer transferred to the substrate A to an image receptor under pressure.

14. A method according to claim 13, wherein the steps (e), (g) and (h) are carried out under heat.

15. A method according to claim 13 or 14, wherein the image-forming members A and B and the image receptor satisfy the following inequalities,

f7 > f8
f10 ≥ f9 > f11

wherein:
f7 = adhesion force between exposed portion of photosensitive layer and substrate A-1,
f8 = adhesion force between exposed portion of photosensitive layer and substrate A,
f9 = adhesion force between nonexposed portion of photosensitive layer and substrate A,
f10 = adhesion force between nonexposed portion of photosensitive layer and substrate A-1, and
f11 = cohesive force of nonexposed portion of photosensitive layer.

16. A method according to any one of the preceding claims wherein the original image is a negative mask.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X,Y | EP-A-255032 (E.I.DU PONT DE NEMOURS AND COMPANY) <br> * the whole document * <br> --- | 1-16 | G03F3/10 <br> G03F7/075 |
| Y | GB-A-1588063 (DAI NIPPON PRINTING CO. LTD) <br> * the whole document * <br> --- | 13 | |
| X | EP-A-365361 (HOECHST CELANESE CORPORATION) <br> * the whole document * <br> --- | 1-12 | |
| A | US-A-4081282 (R.E.MERRIL ET AL.) <br> * the whole document * <br> --- | 1-12 | |
| A | US-A-4288525 (J.V.SHEPHERD ET AL.) <br> * the whole document * <br> --- | 1-12 | |
| A | US-A-4275140 (MELVIN A.NEISS) <br> * the whole document * <br> ----- | 1-12 | |
| | | | **TECHNICAL FIELDS SEARCHED (Int. Cl.5 )** <br><br> G03F |

The present search report has been drawn up for all claims

| Place of search | Date of completion of the search | Examiner |
|---|---|---|
| THE HAGUE | 06 AUGUST 1991 | RASSCHAERT A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

......................................................................................................

& : member of the same patent family, corresponding document

EPO FORM 1503 03.82 (P0401)